# EUROPEAN PATENT APPLICATION

(11) **EP 0 548 596 A2**
(43) Date of publication of application: **30.06.1993**
(21) Application number: 92120442.6
(22) Date of filing: 30.11.1992
(51) Int. Cl.: H01L 21/306, H01L 21/00

(54) **Method and apparatus for cleaning substrate**

(30) Priority: 29.11.1991 JP 316638/91
(71) Applicant: CHLORINE ENGINEERS CORP., Ltd., Tokyo 135 (JP)
(72) Inventor: Matsuoka, Terumi c/o Chlorine Engineers Corp.,Ltd, Okayama 706-01 (JP)
(74) Representative: VOSSIUS & PARTNER

(57) **Abstract**

A method and apparatus for treating substrates, wherein a substrate holder (3) in which the substrates (2) to be treated are put is mounted on a rotary table (5) with a rotary shaft (4) connected thereto in a treating chamber (1), an ozone-containing gas is fed into the treating chamber through an ozone feed nozzle (7) to fill therein with the ozone-containing gas, ultra-pure water is fed onto the substrates through an associated nozzle (9) while they are rotating, thereby treating them with the thin films of ultra-pure water formed on their surfaces, ultra-pure water alone is fed after removal of undesired materials to rinse the substrates, and the substrates are rotated after the interruption of ultra-pure water for spinning off the ultra-pure water and drying, thereby increasing the rate of removal-by-ozone of organic materials, deposits and the like from the substrates, like wafers.

## Description

The present invention relates to a method and apparatus for treating substrates to remove therefrom undesired materials such as organic coatings and deposits, and more particularly to a method and apparatus for treating substrates such as silicon wafers to remove therefrom photoresist films that are organic high-molecular compounds used for producing semiconductor devices, etc., by photolithography, or other undesired materials such as organic or inorganic compound deposits.

In fine fabricating processes inclusive of the process of producing semiconductor devices represented as by ICs and LSIs, silicon or other semiconductor substrates, glass substrates and the like are coated thereon with a photosensitive organic high-molecular compound and exposed to ultraviolet or other rays through a photomask provided therein with a given circuit or other pattern. Then, the photoresist is developed to form a photoresist pattern on the substrate, while a portion of the substrate, on which the photoresist is not formed, is provided thereon with a film as by CVD or sputtering, or subjected to chemical etching or RIE (reactive ion etching), or subjected to the diffusion of impurities' elements by heating or ion implantation. Once a series of treatments has been finished, the photoresist film on the substrate is removed by chemical treatments. In the process of fabricating LSIs, etc., however, photoresist film removal should generally be performed, not in one operation, in several operations after such a photoresist has been coated on the substrate, followed by various treatments.

Various methods have been used for photoresist film removal. Photoresist films must be cleared completely, because incomplete photoresist film removal has an adverse influence on the subsequent steps. Much larger scale integrated semiconductor devices, like those which have recently been fabricated, - this means that the line widths of the circuits formed on semiconductor devices are decreased - are more adversely affected by photoresist film residues or undesired deposits occurring during the production process than are small scale ones. Thus, it is now desired to remove photoresist film residues or undesired deposits completely, and this is usually achieved by either a wet method using liquid chemicals or a dry method using oxygen plasma or ozone-containing gases.

Wet removal of photoresist films usually makes use of sulfuric acid, and hydrogen peroxide is mixed with sulfuric acid in order to enhance its oxidizing power.

When a liquid mixture of sulfuric acid with hydrogen peroxide is used to remove a photoresist film, it is widely practiced to remove liquid deposits comprising sulfuric acid, etc., from the substrate in which the photoresist film has been removed and to wash out residues or undesired deposits by ultra-pure water, etc.

Wet removal of organic coatings from wafers for semiconductors or undesired deposits comprising organic or inorganic compounds is ordinarily achieved by immersing a wafer cassette holding a plurality of the wafers to be treated in a treating tank filled with a treating solution such as a mixed liquid of sulfuric acid with hydrogen peroxide for a given span of time, and then transferring it in a rinsing tank filled with ultra-pure water or other rinsing liquid for immersion, thereby clearing the substrates of liquid deposits, photoresist film residues and other deposits.

An action of nascent oxygen generated by the decomposition of hydrogen peroxide on the oxidative decomposition of the photoresist film plays an important role in photoresist film removal by a liquid mixture of sulfuric acid with hydrogen peroxide. In order to maintain the oxidizing power of this liquid mixture, it is thus required to replace sulfuric acid and hydrogen peroxide by a fresh liquid feed that are consumed by the oxidative decomposition of the photoresist film and are diluted in concentration.

In order to obtain a similar effect without treating a waste liquid that degrades in terms of the power for treating the undersided materials to be removed or supplying a fresh liquid, it has been proposed to supply ozone to sulfuric acid, as set forth in JP-B-52-12063.

Generallyphotoresist films may be removed by introducing ozone in sulfuric acid. When a substrate is subjected to reactive ion etching or doped with impurities by the ion implantation of arsenic, etc., at high concentration, however, some residues often remain on the substrate, because the photoresist film is not completely removed. When the substrate is treated with ions of high energy in the step of ion implantation or other step, this appears to be due to the fact that arsenic, etc., used for ion implantation reacts chemically with the photoresist, so that the photoresist film is converted to a substance unlikely to undergo oxidation and, hence, unlikely to undergo oxidative decomposition by the treating solution.

In addition, solutions used for treating photoresist films are reduced or limited in water content, because sulfuric acid is used therewith at high concentration. Thus, when ozone that has a very low solubility in sulfuric acid is introduced in a high-concentration sulfuric acid solution having a reduced water content, its oxidizing power cannot be effectively exhibited and used, because ozone is less soluble in the sulfuric solution.

In dry treating procedures, on the other hand, high-energy particles as represented by oxygen plasma may in some cases do damage to wafers. A problem with a dry treatment using ozone is that when resists implanted at high doses are treated at relatively high temperatures, pumping, etc., takes place through heat, making some resist residues likely to remain intact.

With the foregoing in mind, the inventors have come up with a- method for washing out organic coatings with a solution of ultra-pure water in which ozone is dissolved or bubbled by making use of the strong oxidative effect of ozone, and have further proposed in U.S. Patent S.N. 07/853,702 to completely remove a photoresist film that has passed through ion implantation and other steps, and cannot be cleared by such a procedure or dry treatments using ozone or other chemicals and so remains deposited on the substrate as residues.

However, there is now an increased demand for treating a large amount of wafers, etc., within a short span of time at higher organic coating removal rates than would be possible with solutions, etc., having ozone dissolved or bubbled in ultra-pure water, which are obtained by supplying ozone-containing gases thereto. A primary object of the invention is to provide a solution to the such problems by increasing the rate of removing undesired matters such as organic coatings and undesired deposits in a wet manner using ozone and so completely removing them within a short span of time.

More specifically, the invention is directed to a method for treating a substrate such as a silicon wafer to remove therefrom undesired materials such as organic coatings and undesired deposits, wherein a treating solution is sprayed onto the undesired materials on the substrate that is rotating in a treating chamber filled with an ozone-containing gas atmosphere.

The treating solution used in the method of the invention, for instance, may be various liquid chemicals, ultra-pure water and a mixed phase fluid comprising an ozone-containing gas and ultra-pure water. This invention is also directed to an apparatus for treating substrates, which comprises a closed treating chamber with a substrate holder located therein, in which a plurality of substrates are placed, said substrate holder being attached to the treating chamber coupled to a rotary shaft or a rotary table coupled to a rotary shaft and being provided with a nozzle for feeding an ozone-containing gas or a treating solution or a nozzle for feeding a mixed phase fluid comprising an ozone-containing gas and a treating solution.

More specifically, the invention is designed such that when various liquid chemicals, ultra-pure water or a mixed phase fluid comprising an ozone-containing gas and ultra-pure water are sprayed onto undesired materials on substrates in a treating chamber having its ozone concentration regulated to a certain or higher level by feeding thereto an ozone-containing gas or a mixed phase fluid comprising an ozone-containing gas and ultra-pure water, the substrates with the undesired materials thereon are rotated to constantly renew thin films of the treating solution on the surfaces of the substrates by means of centrifugal force, thereby promoting removal of the undesired materials.

In this case, however, if the thickness of the water film formed is large, then it is impossible to achieve well-enough treating rates, as experienced in the case of water scattered directly onto the surface of a substrate. Heating the substrates does not permit wet ozone to have well-enough effects, because any thin water film cannot occur even when a wet ozone-containing gas is fed.

By contrast, rotating the substrates at high speed produces large-enough effects, because the thickness of the films of ultra-pure water formed on the surfaces of the substrates are very thin and the films of ultra-pure water formed on the surfaces of the substrates are continuously renewed.

In the method of the invention, it is preferable that the substrates rotate at 10 to 30 r.p.m., when the thin films of the treating solution are formed on the surfaces of the substrates. When the treating solution is used in a gasified or misted form, on the other hand, it is preferable that the substrates rotate at high speed, say, 1,000 r.p.m.

Alternatively, when the ozone-containing gas is fed into the treating chamber without being mixed with ultra-pure water, it is necessary that the concentration of the ozone-containing gas in the treating chamber be maintained at a given value. Although varying depending on the dimensions of the treating chamber, the amount of the ozone-containing gas fed should be determined such that the ozone concentration is regulated to 50,000 ppm or higher.

The mixing of the ozone-containing gas with ultra-pure water, for instance, may be achieved by:
(1) permitting the ozone-containing gas jetted from an ozone-containing gas feed nozzle set up at a given angle to act on a flow of the treating solution jetted from a treating solution feed nozzle, whereby the treating solution and ozone-containing gas are mixed for action on the substrates;
(2) feeding the treating solution and ozone-containing gas to a spiral mixer for mixing and feeding the mixture into the treating chamber;
(3) sucking the ozone-containing gas by a flow of the treating solution moving at a given constant flow rate for mixing;
(4) feeding the ozone-containing gas into a treating solution tank regulated to a given pressure, wherein ozone is first dissolved in the treating solution, and the pressurized ozone-containing treating solution is then depressurized in the treating chamber to release fine bubbles of ozone into the treating solution on the substrates, thereby forming a fluid in a mixed gas-liquid form; or
(5) passing the ozone-containing gas through a gas phase in a treating solution reservoir regulated to saturation vapor pressure and feeding into the treating chamber the resulting carrier gas comprising the ozone-containing gas and the vapor of the treating solution.

After the organic materials have been removed from the surfaces of the substrates, ultra-pure water is fed to the surfaces of the substrates for washing. This substrate washing may be achieved by supplying ultra-pure water alone while the supply of the ozone-containing gas is interrupted, then interrupting the supply of ultra-pure water, then rotating the substrates at high speed to remove the ultra-pure water therefrom, and finally drying the substrates. It is noted in this connection that the treating steps may occur in the same treating chamber.

After the substrates have been treated with the ozone-containing gas fed into the treating chamber, the ozone-containing gas therein is replaced by nitrogen for removal of the ozone-containing gas therefrom, followed by removal of the substrates. This assures that the ozone-containing gas is prevented from leaking out of the treating solution. Since ozone has a very large oxidizing power and so has a harmful influence on human bodies, it is required to decompose the ozone leaving the treating chamber into oxygen through an ozone decomposer.
The invention will be described in detail in connection with the drawings in which
FIGURE 1 represents one embodiment of the method and apparatus for treating substrates according to the invention,
FIGURE 2 illustrates another embodiment of the method and apparatus for treating substrates according to the invention, and
FIGURE 3 shows a further embodiment of the method and apparatus for treating substrates according to the invention.

As already described, the invention is designed such that when various liquid chemicals, ultra-pure water or a mixed phase fluid comprising an ozone-containing gas and ultra-pure water are sprayed onto undesired materials on substrates in a treating chamber having its ozone concentration regulated to a certain or higher level by feeding thereto an ozone-containing gas or a mixed phase fluid comprising an ozone-containing gas and ultra-pure water, the substrates with the undesired matters thereon are rotated to constantly renew thin films of the treating solution on the surfaces of the substrates by means of centrifugal force, thereby promoting removal of the undesired materials.

In this case, however, if the thickness of the water films formed is large, then it is impossible to achieve well-enough treating rates, as experienced in the case of water scattered directly onto the surface of a substrate. Heating the substrates does not permit wet ozone to have well-enough effects, because any thin water film cannot occur even when a wet ozone-containing gas is fed.

By contrast, rotating the substrate at high speed produces large-enough effects, because the thickness of the film of ultra-pure water formed on the surfaces of the substrates is very thin and the film of ultra-pure water formed on the surfaces of the substrates are continuously renewed.

In the method of the invention, it is preferable that the substrates rotate at 10 to 30 r.p.m., when the thin film of the treating solution is formed on the surfaces of the substrates. When the treating solution is used in a gasified or misted form, on the other hand, it is preferable that the substrates rotate at high speed, say, 1,000 r.p.m.

Alternatively, when the ozone-containing gas is fed into the treating chamber without being mixed with ultra-pure water, it is necessary that the concentration of the ozone-containing gas in the treating chamber be maintained at a given value. Although varying depending on the dimensions of the treating chamber, the amount of the ozone-containing gas fed should preferably be determined such that the ozone concentration is regulated to 50,000 ppm or higher.

The mixing of the ozone-containing gas with ultra-pure water, for instance, may be achieved by:
(1) permitting the ozone-containing gas jetted from an ozone-containing gas feed nozzle set up at a given angle to act on a flow of the treating solution jetted from a treating solution feed nozzle, whereby the treating solution and ozone-containing gas are mixed for action on the substrates;
(2) feeding the treating solution and ozone-containing gas to a spiral mixer for mixing and feeding the mixture into the treating chamber;
(3) sucking the ozone-containing gas by a flow of the treating solution moving at a given constant flow rate for mixing;
(4) feeding the ozone-containing gas into a treating solution tank regulated to a given pressure, wherein ozone is first dissolved in the treating solution, and the pressurized ozone-containing treating solution is then depressurized in the treating chamber to release fine bubbles of ozone into the treating solution on the substrates, thereby forming a fluid in a mixed gas-liquid form; or
(5) passing the ozone-containing gas through a gas phase in a treating solution reservoir regulated to saturation vapor pressure and feeding into the treating chamber the resulting carrier gas comprising the ozone-containing gas and the vapor of the treating solution.

After the organic materials have been removed from the surfaces of the substrates, ultra-pure water is fed to the surfaces of the substrates for washing. This substrate washing may be achieved by supplying ultra-pure water alone while the supply of the ozone-containing gas is interrupted, then interrupting the supply of ultra-pure water, then rotating the substrates at high speed to remove the ultra-pure water therefrom, and finally drying the substrates. It is noted in this connection that the treating steps may occur in the same treating chamber.

As can be understood from the foregoing, the invention provides a method for treating substrates such as silicon wafers for fabricating semiconductor devices to remove therefrom undesired materials such as organic coatings and deposits by spraying a treating solution such as ultra-pure water onto the substrates that rotate in an ozone-containing atmosphere, thereby forming on the surfaces thereof continuously renewed ultra-pure water films. This method is higher in removal rates than conventional wet removal of organic coatings by ultra-pure water implanted with ozone or conventional dry removal of organic coatings by ozone acting on heated substrates, so that the undesired materials can be removed within a shorter span of time.

The invention will now be explained, more specifically but not exclusively, with reference to the accompanying drawings.

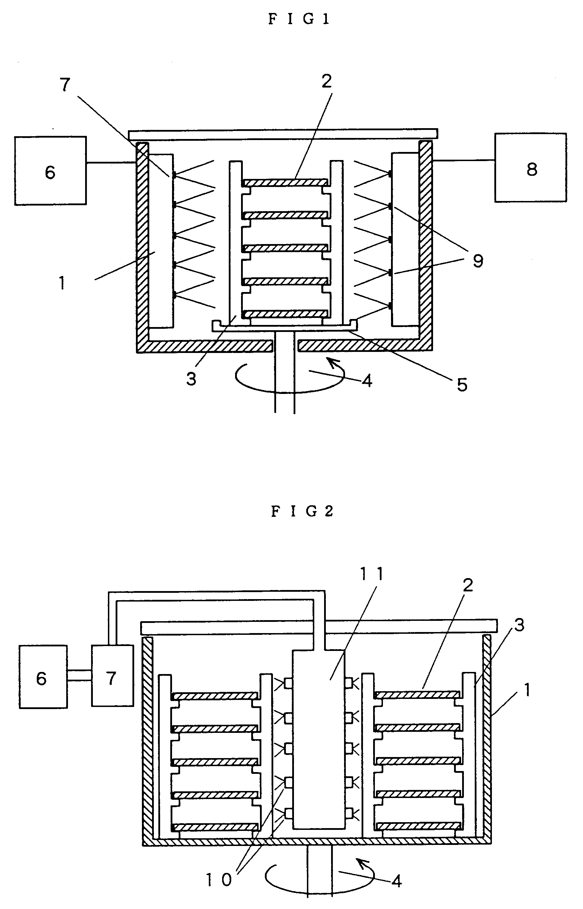

Fig. 1 illustrates one embodiment of the method of the invention.

Within a treating chamber 1, there is provided a substrate holder 3 with a plurality of substrates 2 held in place, which is mounted on a rotary table 5 connected to a rotary shaft 4. The treating chamber 1 has also an ozone feed nozzle 7 for feeding an ozone-containing gas generated by an ozone generator 6 and an ultra-pure water feed nozzle 9 for jetting ultra-pure water fed through an ultra-pure water feed unit 8.

The ozone-containing gas is first fed into the treating chamber through the ozone feed nozzle 7. Just when the ozone concentration in the treating chamber is stabilized, the ultra-pure water is jetted through the nozzle 9 while the rotary table is rotating, so that the thin films of ultra-pure water are formed on the surfaces of the substrates. The jetting of ultra-pure water may be performed either continuously or intermittently. After the substrates have been treated for a given time and thereby cleared of organic coatings, ultra-pure water alone is subsequently supplied for substrate rinsing to remove residues from the surfaces of the substrates. Then, the supply of ultra-pure water is interrupted, but the rotation of the substrates is continued for spinning off the ultra-pure water and drying.

Fig. 2 represents another embodiment of the invention.

Within a treating chamber 1, there is provided a substrate holder 3 within a number of substrates 2 held in place, and a fluid spray unit 11 having a number of spray nozzles 10 is located in the vicinity of the holder 3. Through this fluid spray unit, an ozone-containing gas generated by an ozone generator 6 and ultra-pure water fed from an ultra-pure water feed unit 12 - which are mixed in a gas-liquid mixer 13- are sprayed onto the surfaces of the substrates.

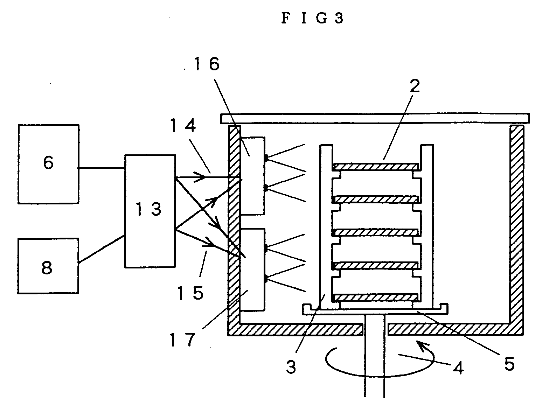

Fig. 3 shows a further embodiment of the invention.

As illustrated, a substrate holder 3 is mounted on a rotary table 5 coupled to a rotary shaft 4. An ozone-containing gas obtained in an ozone generator 6 and ultra-pure water supplied from an ultra-pure water feed unit 12 are mixed in a gas-liquid mixer 13, whence a wet ozone-containing gas 14 and an ozone-containing ultra-pure water 15 are separately sprayed through spray nozzles 16 and 17 onto the surfaces of the rotating substrates for treating them. After that, the rotary shaft is rotated at high speed for spinning off the ultra-pure water.

### Example 1

A positive type of photoresist (OFPR-800 made by Tokyo Ohk Kogyo K.K.) was coated on each of 150-mm diameter silicon wafers cleaned on the surfaces by means of a spin coater in such a way that its thickness after prebaking was 1,100 nm.

The substrates, each with the photoresist side upward, were put in the holder in the treating chamber, and the ozone-containing gas of 55,000 ppm in ozone concentration was then fed through the ozone feed nozzle in an amount of 6 liters/minute. Once the ozone concentration had been stabilized in the treating chamber, the holder was rotated at 200 to 750 r.p.m., while ultra-pure water of 25°C was sprayed onto the substrates at a flow rate of 200 to 1,000 ml/minute through the ultra-pure water spray nozzle, thereby removing organic coatings from the surfaces of the substrates. The results are set out in Table 1.

**Table 1**

| Ozone Conc. (ppm) | Gas Flow Rate liters/min. | R.P.M. | Treating Time (min.) | Removal Rate nm/min. |
|---|---|---|---|---|
| 55,000 | 6 | 750 | 5 | 177 |
| 55,000 | 6 | 750 | 5 | 126 |
| 55,000 | 6 | 200 | 5 | 136 |

### Comparative Example 1

Wafers with photoresists mounted thereon in similar manners as in Example 1 were treated at 20°C for 5 minutes with an ozone-containing gas of 8,000 ppm in ozone concentration that was free from water. However, the photoresists remained invariable in the initial thickness; in other words, they could not be removed.

## Claims

1. A method for treating substrates such as semiconductor wafers, wherein a treating solution is sprayed on undesired materials on the surfaces of the substrates, while the substrates are rotating, in an ozone-containing gas atmosphere.

2. A method as claimed in Claim 1, wherein the treating solution is ultra-pure water.

3. A method as claimed in Claim 1 or 2, wherein the ozone-containing gas atmosphere is created by feeding a mixed phase fluid comprising an ozone-containing gas and ultra-pure water as the treating solution.

4. An apparatus for treating substrates such as semiconductor wafers to remove undesired materials therefrom, which includes a closed treating chamber, a substrate holder for holding a plurality of substrates, said substrate holder being mounted on the treating chamber to which a rotary shaft is connected or a rotary table coupled to a rotary shaft, and a nozzle for feeding an ozone-containing gas and a treating solution or a nozzle for feeding a mixed phase fluid comprising an ozone-containing gas and a treating solution.

5. An apparatus as claimed in Claim 4, wherein the treating solution is ultra-pure water.
